Europäisches Patentamt

European Patent Office

Office européen des brevets

(11) Veröffentlichungsnummer: **0 349 555 B1**

(12) **EUROPÄISCHE PATENTSCHRIFT**

(45) Veröffentlichungstag der Patentschrift: **16.06.93**

(21) Anmeldenummer: **88902393.3**

(22) Anmeldetag: **16.03.88**

(86) Internationale Anmeldenummer:
**PCT/DE88/00152**

(87) Internationale Veröffentlichungsnummer:
**WO 88/07259 (22.09.88 88/21)**

(51) Int. Cl.5: **H01J 27/18**

(54) **HOCHFREQUENZ-IONENQUELLE.**

(30) Priorität: **18.03.87 DE 3708716**

(43) Veröffentlichungstag der Anmeldung:
**10.01.90 Patentblatt 90/02**

(45) Bekanntmachung des Hinweises auf die
Patenterteilung:
**16.06.93 Patentblatt 93/24**

(84) Benannte Vertragsstaaten:
**AT BE CH DE FR GB IT LI LU NL SE**

(56) Entgegenhaltungen:
**FR-A- 2 359 996**
**GB-A- 1 399 603**
**US-A- 3 634 704**

**Patent Abstracts of Japan, Band 10, Nr. 186
(E-416)(2242), 28 Juni 1986 & JP A 6134832
(HITACHI LTD) 19. Februar 1986**

**Nuclear Instruments and Methods in Physics Research B6, 1985, Elsevier Science
Publ. (Amsterdam, NL) M. Iwaki et al.: "Riken
200 kV high current implanter for metal surface modification", Seiten 51-55**

(73) Patentinhaber: **Oechsner, Hans, Professor Dr.
rer nat.
Vogelweher Strasse 76
W-6750 Kaiserslautern(DE)**

(72) Erfinder: **Oechsner, Hans, Professor Dr. rer
nat.
Vogelweher Strasse 76
W-6750 Kaiserslautern(DE)**

(74) Vertreter: **Liesegang, Roland, Dr.-Ing. et al
FORRESTER & BOEHMERT Franz-
Joseph-Strasse 38
W-8000 München 40 (DE)**

Rank Xerox (UK) Business Services
(3. 10/3.6/3.3. 1)

**Beschreibung**

Die Erfindung betrifft eine Hochfrequenz-Ionenquelle zur Erzeugung von großflächigen Ionenstrahlen mit einem Gefäß für die zu ionisierenden Stoffe, insbesondere Gase, wobei induktiv Hochfrequenzenergie in das Plasma einkoppelbar und ein schwaches Gleichmagnetfeld vorgesehen ist.

Großflächige Ionenquellen werden für die verschiedensten Verwendungszwecke benötigt. Sie stellen beispielsweise ein unentbehrliches Werkzeug für die moderne Oberflächen- und Dünnschichttechnologie dar. Typische Einsatzfelder sind u.a. die großflächige Abtragung von einheitlichen oder mit strukturerzeugenden Masken bedeckten Festkörperoberflächen (Ionenstrahlätzen) oder die großflächige Ionenstrahlzerstäubung eines oder mehrerer Festkörpertargets zur Erzeugung von dünnen Oberflächenschichten oder von Dünnschichtsystemen.

Die hierfür im Einsatz befindlichen großflächigen Ionenquellen bestehen in der Regel aus einem Bündel aus vielen einzelnen Ionenstrahlen, die aus einem Niederdruckplasma mittels einer oder mehrerer hintereinander liegender, siebartiger, gegen das Plasma negativ gepolter Elektroden extrahiert werden. Das erforderliche Niederdruckplasma wird in bekannter Weise im jeweiligen Arbeitsgas durch Elektronenstoßionisation erzeugt. Die erforderlichen Elektronen liefern meist Elektronenquellen verschiedenster Bauart mit nachgeschalteter Elektronenbeschleunigungsstrecke.

Solche Ionenquellen besitzen jedoch im Dauerbetrieb oder bei bestimmten Arbeitsgasen erhebliche Nachteile. So weisen beispielsweise thermionische Elektronenemitter ("Glühkathoden") nur eine begrenzte Lebensdauer auf. Bei Verwendung reaktiver Arbeitsgase werden sie sehr rasch vergiftet oder völlig zerstört. Wegen der begrenzten lateralen Ausdehnung von Elektronenemittern oder anderen Elektronenquellen lassen sich Plasmen mit großem Querschnitt nur durch Verwendung nebeneinander liegender Elektronenquellen realisieren, wobei es zu einer ungleichförmigen Verteilung der Plasmadichte und damit der Ionenstromdichteverteilung im extrahierten Ionenstrahlbündel kommt. Wegen der erforderlichen Strom- und Spannungsversorgungen für die zur Plasmaerzeugung erforderlichen Elektronenquellen ist es außerdem technisch aufwendig, solche Quellen auf hohem elektrischen Potential zu betreiben, d.h. den Ionenstrahl von einem hohen Potential aus auf ein geerdetes Werkstück zu beschleunigen.

Aus GB-A-1 399 603 sind Ionenquellen bekannt, bei denen ein Gleichmagnetfeld stets axial in bezug auf die Gefäßachse wirkt und im wesentlichen durch gezielte Ausnutzung der Feldinhomogenität zur Fokussierung des Quellenplasmas in Richtung auf den Extraktionsbereich dient. Dabei wird ein starkes Magnetfeld verwendet und das Gefäß hat immer die gleiche, zylindrische Form.

In Patent Abstracts of Japan, Band 10, Nr. 186 (E-416) (2242), 28. Juni 1986 + JP-A-613 48 32 sind Einzelheiten einer Ionenquelle angegeben, so beispielsweise ein Ionenextraktionssystem mit mehreren Extraktionselektroden, wobei eine Elektrode eine Suppressionsspannung aufweisen kann.

Auch in FR-A-2 359 996 sind Details zu einer Ionenquelle enthalten, u.a. was eine Extraktionselektrode aus nichtleitfähigem Material anbelangt.

Der Erfindung liegt die Aufgabe zugrunde, eine Hochfrequenz-Ionenquelle der eingangs näher bezeichneten Art zu schaffen, mit der großflächige, stromstarke Ionenstrahlen beliebiger Querschnittsgeometrie, z.B. in Bandform, aus Ionen beliebiger Art erzeugt werden können.

Diese Aufgabe wird erfindungsgemäß dadurch gelöst, daß in einem rohrförmigen, der Form des gewünschten Ionenstrahls angepaßten Plasmagefäß, das zwischen eine Trägerplatte und eine Abschlußplatte geklemmt ist, bei Gasdrücken im Hochvakuum-Bereich eine Plasmaanregung durch Elektronenzyklotronwellen resonant in Bezug auf die Plasmagefäß-Dimension durchführbar ist, daß zwischen dem Hochfrequenzgenerator und der Lastkreisspule ein abstimmbarer Zwischenkreis angeordnet ist, daß das schwache Gleichmagnetfeld, das aufgrund der Theorie der Elektronenzyklotronwellen-Resonanz senkrecht zur Achse der Lastkreisspule gerichtet sein muß und dessen Höhe sich aus dieser Theorie ergibt, mit einem Helmholtz-Spulenpaar erzeugt ist, dessen geometrische Gestalt der Form des Plasmagefäßes angepaßt ist, und daß in der Trägerplatte ein aus mehreren Elektroden bestehendes ionenoptisches, der Geometrie des gewünschten Ionenstrahls angepaßtes System zur Ionenextraktion angeordnet ist.

Nach einer weiteren Ausbildung der Erfindung ist vorgesehen, daß als System zur Ionenextraktion eine erste und eine zweite Extraktonselektrode vorgesehen sind, an die eine Spannung als Potentialstufe zur Trennung nachionisierter injizierter Fremdteilchen von Plasmaionen angelegt ist und daß weitere Elektroden mit angelegten Ionenbeschleunigungsspannungen und eine Suppressionselektrode vorgesehen sind.

Eine andere Ausbildung der Erfindung besteht darin, daß die erste Extraktionselektrode aus nichtleitfähigem Material hergestellt ist und die Spannungen der weiteren Elektroden gegen die zweite Extraktionselektrode angelegt sind.

Erfindungsgemäß kann vorgesehen sein, daß das Plasmagefäß quaderförmig mit abgerundeten Seiten und offenen Stirnflächen ausgebildet ist und das System zur Ionenextraktion schlitzförmige Elektroden aufweist.

Im Rahmen der Erfindung liegt es auch, wenn auf der Abschlußplatte ein Zerstäubungstarget angeordnet ist.

Andererseits kann es erfindungsgemäß zweckmäßig sein, wenn die Abschlußplatte über Öffnungen mit einem Vakuum-Gefäß verbunden ist, in dem Widerstands- oder Elektronenstrahl-Verdampfer angeordnet sind.

Die mit der Erfindung erzielten Vorteile bestehen insbesondere darin, daß die Plasmaerzeugung völlig elektrodenlos nur durch äußere Elemente in einem Plasmagefäß mit einfacher beliebiger geometrischer Form erfolgt. Alterungs- oder Vergiftungserscheinungen, wie sie etwa bei Ionenquellen mit einer zusätzlichen Elektronenquelle auftreten, sind daher ausgeschlossen. Die neue Hochfrequenz-Ionenquelle unter Ausnutzung der Elektronenzyklotronwellen-Resonanz weist daher im Vergleich zu anderen Ionenquellen eine sehr hohe Betriebsdauer auf. Die geometrisch einfache Gestalt des Entladungsraumes ist vakuumtechnisch von erheblichem Vorteil. Hervorzuheben ist ferner die hohe Reinheit der Hochfrequenz-Ionenquelle, da das geometrisch einfach gestaltete Entladungsgefäß aufgrund der Erwärmung durch die hochfrequenten dielektrischen Verluste in der Gefäßwand ständig "ausgeheizt" wird, wobei die auftretenden Temperaturen 100 Grad C in der Regel nicht überschreiten.

Von Vorteil ist weiter, daß am Plasmagefäß nur niedrige Hochfrequenzspannungen auftreten. Dadurch werden störende Hochfrequenzaufladungen, die zur Zerstäubung von Wänden und Bauteilen fuhren können, weitgehend vermieden.

Entscheidend für die praktischen Anwendungen solcher Quellen ist auch der im Vergleich zu anderen Quellentypen niedrige Arbeitsdruck. Damit wird es möglich, zur Ionenextraktion flachgebaute Ionenoptiken mit großen Öffnungen zu verwenden und gleichzeitig im Beschußraum oder in nachfolgenden Ionenbeschleunigungsstrecken den erforderlichen niedrigen Gasdruck aufrechtzuerhalten.

Ein weiterer entscheidender Vorteil liegt darin, daß die Plasmaerzeugung in rein induktiver Ankopplung erfolgt. Damit wird es möglich, den Lastkreis mit dem Plasmagefäß gleichspannungsmäßig vom Hochfrequenzgenerator und etwaigen Ankoppelkreisen elektrisch zu isolieren. So kann das Hochfrequenzplasma als ionenerzeugendes Element auf ein praktisch beliebig hohes elektrisches Potential gegenüber dem in Erdnähe betriebenen Hochfrequenz-Generator gelegt werden. Die elektrische Isolation kann dabei in einem Schritt zwischen der letzten Ankoppelspule und der Lastkreisspule erfolgen oder schrittweise etwa zwischen der Auskoppelspule des Hochfrequenzgenerators und der ersten Koppelspule eines Zwischenkreises sowie anschließend zwischen der zweiten Spule des Zwischenkreises und der Lastkreisspule. Das erzeugte Niederdruckplasma ist schließlich selbst von der Lastkreisspule noch durch die aus Isolatormaterial bestehende Wand des Plasmagefäßes von der Lastkreisspule elektrisch isoliert. Die zur Erzeugung des erforderlichen Gleichmagnetfeldes benötigten Spulen (vorzugsweise in Helmholtz-Geometrie) können in genügend großen Abstand zum elektrisch hochliegenden Teil der Anordnung (Lastkreisspule bzw. Plasma) angeordnet und damit ebenfalls nahe dem Erdpotential betrieben werden.

Ein Ausführungsbeispiel ist in den Zeichnungen dargestellt und wird im folgenden näher erläutert.

Es zeigen

Fig. 1 und Fig. 2     Prinzipschaltbilder der Hochfrequenz-Ionenquelle,

Fig. 3 und Fig. 4     Einzelheiten zu dem Plasmagefäß in zwei Ansichten,

Fig. 5     schematisch ein System zur Ionenextraktion,

Fig. 6     die Abschlußplatte mit einem Zerstäubungstarget und

Fig. 7     die mit Öffnungen versehene Abschlußplatte, an die ein Vakuum-Gefäß mit Elektronenstrahl-Verdampfern angeflanscht ist.

Die Hochfrequenz-Ionenquelle benutzt zur Plasmaerzeugung die Methode der Elektronenzyklotronwellen-Resonanz.

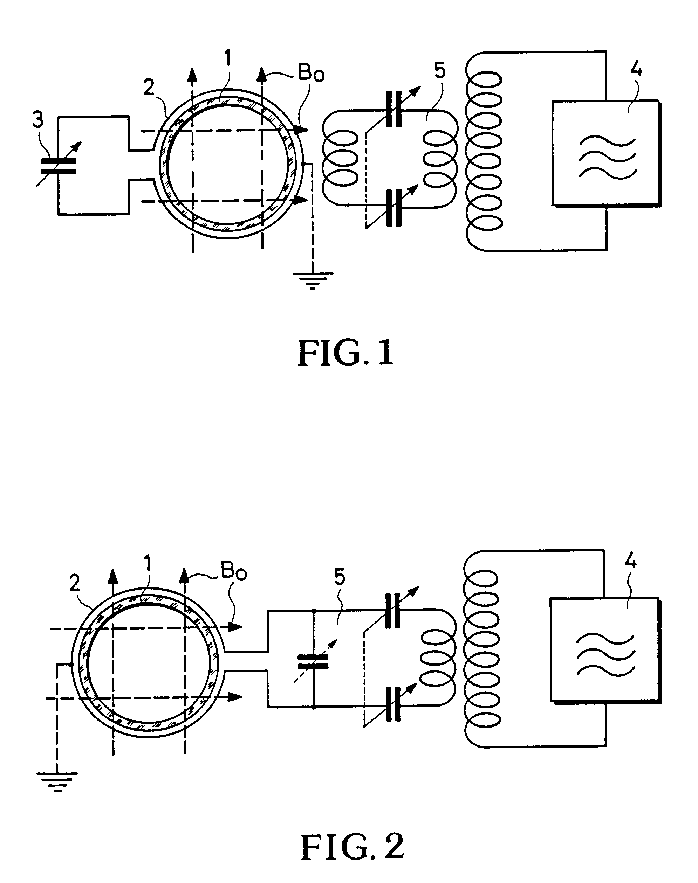

Dazu wird, wie Fig. 1 zeigt, durch eine um ein Plasmagefäß 1 gelegte vorzugsweise einwindige Spule 2, die zusammen mit einem abstimmbaren Kondensator 3 einen elektrischen Schwingkreis bildet, Hochfrequenz-Energie in das Plasma eingekoppelt. Diese sogenannte Lastkreisspule 2 wird nun induktiv oder durch direkte elektrische Verbindung (Fig. 2) an einen Hochfrequenz-Generator 4 angekoppelt, wobei zwischen dem Hochfrequenz-Generator 4 und der Lastkreisspule 2 ein weiterer abstimmbarer Zwischenkreis 5 dazwischengeschaltet werden kann.

Bei genügend hohem Gasdruck (typischerweise $10^{-2}$ - $10^{-1}$ mbar) im Plasmagefäß 1 entsteht durch die Wirkung des hochfrequenten elektrischen Wirbelfeldes ein elektrisches Gasentladungsplasma. Ausschlaggebend für die Plasmaanregung durch die Elektronenzyklotronwellen-Resonanz ist nun, daß der Anordnung ein möglichst homogenes schwarches Gleichmagnetfeld $B_o$ senkrecht zur Achse der Lastkreisspule 2 überlagert wird. Ein solches Gleichmagnetfeld dessen Winkel-Orientierung in den Zeichenebenen der Figuren 1 und 2 frei wählbar ist (diese Figuren zeigen zwei alternative Winkellagen eines Gleichmagnetfil-

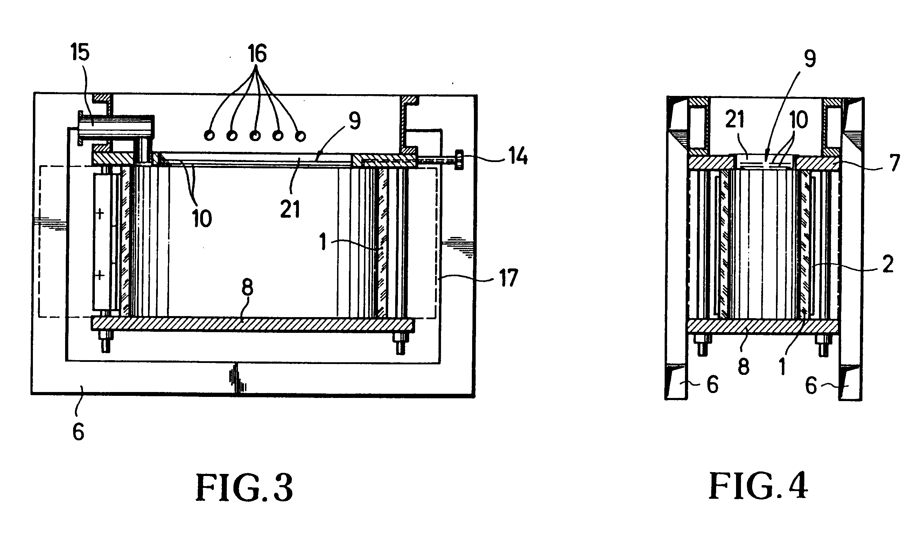

des $B_o$ als Beispiele), wird in vorteilhafter Weise durch ein Helmholtz-Spulenpaar 6 (Fig. 3, 4) erzeugt, dessen geometrische Gestalt der Form des Plasmagefäßes 1 angepaßt werden kann. Unter der Wirkung von $B_o$ wird das angeregte Niederdruckplasma hinsichlich seiner elektrischen Eigenschaften anisotrop, wobei durch die Richtung von $B_o$ die Anisotropieachse vorgegeben ist. Laufen nun, von der Lastkreisspule 2 ausgehend, elektromagnetische Wellen in das jetzt elektrisch anisotrope leitfähige Medium "Plasma" ein, so zeigen die für diesen Fall berechneten Dispersionsrelationen, daß Wellenausbreitung in bekannter Weise oberhalb der durch die Anwesenheit des Gleichmagnetfeldes $B_o$ modifizierten Plasmafrequenz $\omega_{pl}$ stattfindet. Betrachtet man jedoch die Dispersionsrelationen für den rechtszirkularen und den linkszirkularen Anteil eine reinfallenden ebenen Welle separat, so zeigt sich, daß für die rechtszirkulare Teilwelle auch in einem Frequenzgebiet unterhalb der Elektronenzyklotronfrequenz $\omega_{c,e}$ Wellenausbreitung möglich ist, wenn der Wellenvektor k der betrachteten ebenen Welle in Richtung der Anisotropieachse des leitfähigen Mediums, d.h. in Richtung von $B_o$ liegt. Resonante Plasmaanregung durch diese sogenannten Elektronenzyklotronen-Wellen mit einer Frequenz $\omega < \omega_{c,e}$ erfolgt unter Berücksichtigung der durch die umgebende Lastkreisspule 2 vorgegebenen Randbedingungen dann, wenn die Plasmalänge d in der Laufrichtung der rechtszirkularen Elektronenzyklotronwelle jeweils ein ungeradzahliges Vielfaches der halben Wellenlänge dieser Wellen beträgt, d.h., wenn gilt

$$\lambda_{res} = 2\, d\, /\, (2z\, +\, 1).$$

Dabei stellt z die Ordnung der Resonanz dar. Für die jeweiligen Resonanzfrequenzen $\omega_z$ ($z = 0, 1, 2...$) mit $\omega_z < \omega_{c,e}$ stellt die Elektronenzyklotron-Frequenz $\omega_{c,e}$ einen Häufungspunkt dar. Dies bedeutet, daß bei einer durch den Hochfrequenzgenerator vorgegebenen Anregungsfrequenz $\omega$ die Elektronenzyklotronwellen-Resonanz einer bestimmten Ordnung z durch die geeignete Wahl der Größe des überlagerten Gleichmagnetfeldes $B_o$, die ihrerseits $\omega_{c,e}$ bestimmt, eingestellt werden kann. In der Praxis ist die Anregung mit der Grundresonanz bei $\omega_o$ oder der ersten Oberresonanz bei $\omega_1$ von Bedeutung.

Erklärend sei noch angefügt, daß die relative Dielektrizitätskonstante DK des Plasmas im Bereich der Propagation der Elektronenzyklotronwellen sehr groß wird. Damit wird die Wellenlänge der Elektronenzyklotronwellen, die sich aus der Vakuum-Wellenlänge durch die Division mit der Wurzel aus der DK ergibt, so klein, daß sie mit den Abmessungen des Plasmagefäßes 1 vergleichbar wird. Die zugehörigen DK-Werte sind eine Funktion der Elektronendichte, d.h. der Dichte des erzeugten Niederuckplasmas und der Gefäßgeometrie.

Die Plasmaanregung durch Elektronenzyklotonwellen-Resonanz wird umso effektiver, je niedriger der Gasdruck ist, da dann der Einfluß der Resonanzdämpfung durch Stöße von Plasmateilchen untereinander immer geringer wird. Der kleinste Arbeitsdruck für die resonante Anregung durch Elektronenzyklotronwellen wird dann erreicht, wenn bei immer kleiner werdender Gasdichte im Plasmavolumen nicht mehr genügend neutrale Gasatome zur Verfügung stehen, durch deren Ionisation die Teilchenverluste an den Gefäßwänden kompensiert werden. Je nach Gefäßgröße liegt für Argon als Arbeitsgas dieser untere Grenzdruck bei $10^{-4}$ mbar, dagegen beispielsweise für Xenon unterhalb von $10^{-6}$ mbar. Bei genügend guter Anpassung der durch das Plasma gegebenen Last an den Hochfrequenzgenerator 4 und bei hochfrequenztechnischer Optimierung der Anordnung lassen sich bei Arbeitsdrücken im $10^{-4}$ mbar-Bereich Plasmaionisierungsraten um $10^{-2}$ erzielen.

Eine praktische Ausführung einer Hochfrequenz-Ionenquelle mit Elektronenzyklotronwellen-Resonanz zur Plasmaanregung zeigen die Fig. 3 und 4. Mit dieser Ionenquelle soll ein bandförmiger Ionenstrahl erzeugt werden, der anschließend beispielsweise durch eine aus zwei Kondensatorplatten bestehende elektrische Ablenkeinrichtung senkrecht zu seiner Längsseite periodisch abgelenkt werden kann, oder der in einer Ionenimplantationsanordnung durch nachfolgende schlitzartige Elektroden weiter beschleunigt wird und dann als bandförmiger hochenergetischer Ionenstrahl auf ein zu implantierendes Werkstück auftrifft (nicht dargestellt).

Die Form des Plasmagefäßes 1 ist in vorteilhafter Weise der Form des gewünschten bandförmigen Ionenstrahls angepaßt. Es besteht aus einem quaderförmigen rohrartigen Glasgefäß mit abgerundeten Seiten und offenen Stirnflächen (Fig. 3, 4). Das Plasmagefäß 1 ist zwischen eine Trägerplatte 7 und eine Abschlußplatte 8 geklemmt.

In der einen Stirnfläche ist das Extraktionssystem zur Erzeugung des Ionenstrahles angeordnet. Auch das Extraktionssystem 9 kann in seiner geometrischen Form in der erforderlichen Weise an die jeweils benötigte Querschnittsform des Ionenstrahles oder eines ganzen Ionenstrahlbündels angepaßt werden. In dem in Fig. 3 und 4 gezeigten Ausführungsbeispiel besteht das Ionenextraktionssystem 9 aus zwei ebenen hintereinander liegenden und zueinander justierten Elektroden 10 mit schlitzförmigen Öffnungen, wobei die Elektrode mit der größeren Schlitzbreite plasmaseitig und die mit der kleineren Schlitzbreite beschußraumseitig angeordnet ist.

In Fig. 3, 4 ist mit 14 der Gaseinlaß bezeichnet und 15 ist ein Stutzen zum Anschluß von Meßgeräten für die Plasmadruckbestimmung. 16 sind elektrische Durchführungen für die Anschlüsse der Extraktionselektroden 10. Mit 17 ist eine Abschirmung bezeichnet.

Die plasmaseitige Elektrode 10 liegt auf relativ niedrigem Potential gegen das Plasma (ca. um 50 Volt negativ gegen das Plasma); die Ionenbeschleunigung erfolgt vorwiegend im elektrischen Feld zwischen der ersten und der zweiten Extraktionselektrode 10, die voneinander einen Abstand von einigen mm haben. Je nach der elektrischen Isolation zwischen den beiden hintereinander montierten Extraktions- oder Ionenlinsen-Elektroden 10 lassen sich die extrahierten Plasmaionen auf Energien bis zu mehreren keV beschleunigen.

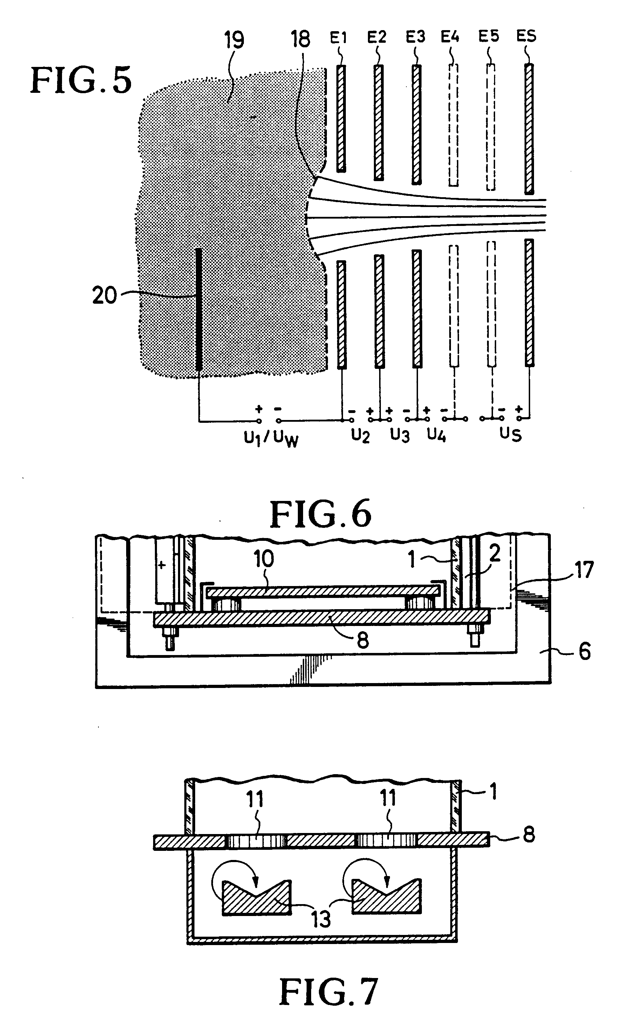

Die ionenemittierende Plasmagrenzfläche 18 oberhalb der Öffnung des Extraktionssystems 9 sowie dessen Elektroden bilden gemeinsam ein ionenoptisches "Immersionssystem", mit dem beispielsweise eine Srahlfokussierung möglich ist (Fig. 5). Durch die zum Plasma 19 hin gekrümmte Form der ionenemittierenden Plasmagrenzfläche 18 werden aus einem größeren Bereich Plasmaionen extrahiert, als es der geometrischen Öffnung der plasmaseitigen Extraktionselektrode E1 entspricht. Die Fokussierungsbedingungen für den extrahierten Ionenstrahl und damit dessen geometrische Querschnittsform lassen sich durch die elektrischen Potentiale an den Extraktionselektroden $E_1$, $E_2$ sowie durch die geometrische Anordnung (Breite der Extraktionsöffnungen, Abstand der Extraktionselektroden etc.) steuern. Der beschußraumseitigen Extraktionselektrode $E_2$ können eine oder mehrere, beispielsweise blendenartig ausgestattete Elektroden $E_3$ ...$E_n$ zur weiteren Beschleunigung des Ionenstrahles folgen. Die Spannung $U_2$ ergibt eine Potentialstufe zur Trennung nachionisierter injizierter Fremdteilchen von Plasmaionen. $U_3$ und $U_4$ sind weitere Ionenbeschleunigungs-Spannungen an den Extraktionselektroden $E_3$ und $E_4$. $U_s$ ist eine Spannung an der Suppressionselektrode $E_s$, um den Abflug von Elektronen aus dem Ionenstrahl zurück in das Plasma 19 zu unterdrücken.

Wie in Fig. 5 skizziert, können die elektrischen Potentiale an den Extraktionselektroden $E_1$...$E_n$ und an der Suppressionselektrode $E_s$ gegen eine weitere Bezugselektrode 20 angelegt werden, die in Kontakt mit dem Plasma 19 steht. Diese Bezugselektrode 20 kann entweder eine metallische Abschlußfläche an der Stirnfläche des Plasmas 19 sein, die dem Extraktionssystem 9 gegenüberliegt. Als Bezugselektrode 20 zum Anlegen der Extraktionsspannungen kann aber auch eine stiftförmige ins Plasma hineinragende weitere Elektrode benutzt werden, die durch geeignete Wahl ihrer dem Plasma 19 ausgesetzten geometrischen Fläche beliebig gut auf das Potential des sie umgebenden Plasmas 19 selbst gebracht werden kann.

Mit einem Prototyp einer solchen Hochfrequenz-Ionenquelle wurde mittels eines aus zwei schlitzförmigen Elektroden bestehenden Ionenextraktionssystems 9 aus Niederdruck-Plasmen in Argon und in Stickstoff ein bandförmiger Ionenstrahl mit einer Gesamtbreite von 20 cm extrahiert, dessen Dicke beim Austritt aus der beschußraumseitigen Extraktionselektrode 2 mm betrug. Bei einer Ionen-Extraktionsenergie von 3 keV lag der gesamte extrahierte Ionenstrom im bandförmigen Ionenstrahl zwischen 25 und 30 mA. Bei einem Arbeitsgasdruck von einigen $10^{-4}$ mbar betrug die Verlustleistung im Plasma ca. 150 Watt. Die Plasmaanregung erfolgte bei einer Frequenz von 27,12 MHz.

Eine weitere Möglichkeit zur Ionenextraktion besteht darin, die plasmaseitige erste Elektrode $E_1$ des Extraktionssystems 9 als sogenannte isolierte Electrode zu betreiben, gegen die sich das Plasma 19 von selbst zur Aufrechterhaltung seiner Quasi-Neutralität auf ein positives Potential einstellt.

Die nachfolgende Spannung zwischen der zweiten oder weiteren Extraktonselektroden ($E_2$...$E_n$) werden dann gegen die plasmaseitige zweite Extraktionselektrode angelegt.

Eine solche isolierte Elektrode E1 kann auch aus nichtleitfähigem Material, etwa in Form einer geschlitzten Quarzplatte, ausgeführt werden. Zwischen dem Plasma 19 und einer isolierten Elektrode E1 stellt sich wie auch gegenüber der Gefäßwand insgesamt ein Spannungsabfall $U_w$ ein, der gegeben ist durch

$$U_w = \frac{k \cdot T_e}{2 e_o} l_n \left( \frac{M_i}{\alpha^2 \cdot 2\pi \cdot m_e} \right)$$

($T_e$ Temperatur der Plasmaelektronon, $m_e$ Elektronenmasse, $M_i$ Ionenmasse, k Boltzmann-Konstante, $\alpha$ empirischer Faktor mit einem Wert von etwa 0,8, $\pi$ = 3,14..., $e_o$ Elementarladung, $l_n$ Abkürzung für natürlicher Logarithmus.) Durch diesen Potentialabfall $U_w$, bei dem die erwähnte aus Isolationsmaterial angefertigte zum Beispiel schlitzförmige Elektrode $E_1$ auf negativem Potential gegen das Plasma 19 liegt, werden positive Plasmaionen auf diese hin beschleunigt und treten durch den eingearbeiteten Schlitz oder eine anders geformte Öffnung aus. Anschließend können die austretenden Plasmaionen durch ein ionenoptisches System ($E_2...E_n$) weiter beschleunigt und geometrisch zu einem Ionenstrahl gebündelt werden, dessen geometrische Form durch die Öffnung in dem erwähnten Bauteil und die Form der Öffnungen in der Ionenbeschleunigungsoptik bestimmt wird. Die erforderliche Quasi-Neutralität des Plasmas wird dadurch gewährleistet, daß durch die Öffnung in der isolierten Elektrode $E_1$ ebenso viele Elektronen hindurchtreten wie Ionen. Auf diese Weise können auch etwaige störende Aufladungen der Beschleunigungselektroden $E_2...E_n$ sowie von $E_s$ vermieden werden.

Da wegen der elektrodenlosen Methode der Plasmaanregung durch Elektronenzyklotronwellen-Resonanz keinerlei Elektroden im Plasmaraum erforderlich sind, kann das gesamte übrige Plasmagefäß einschließlich der Abschlußplatte 8, die der Ionenaustrittsfläche 21 gegenüberliegt, ebenfalls aus einem Isolatormaterial, wie beispielsweise Quarz, ausgefuhrt werden. Damit kann dei gesamte Wand des ionenerzeugenden Plasmagefäßes 1 aus einem Material hergestellt werden, das gegen chemisch aggressive Gase resistent ist. Die Hochfrequenz-Ionenquelle kann daher auch zur Erzeugung eines beliebig geformten großflächigen Ionenstrahls oder Ionenstrahl-Bündels aus Ionen aggressiver oder reaktiver Gase benutzt werden. Das hinter der Ionenaustrittsfläche 21 angeordnete Ionenbeschleunigungssystem wird bei geeigneter geometrischer Ausführung und bei geeigneter Potentialgebung vom extrahierten Ionenstrahl nicht berührt und wird daher ebenfalls durch die extrahierten reaktiven oder chemisch agressiven Ionen nicht in Mitleidenschaft gezogen.

Zahlreiche Untersuchungen zur Größe der Elektronen-Temperatur $T_e$ in einem durch Elektronenzyklotronwellen-Resonanz angeregten Niederdruckplasma haben ergeben, daß $T_e$ in der Größenordnung von 100.000 K (Kelvin) liegt und daß die Plasmaelektronen in sehr guter Näherung einer maxwellschen Geschwindigkeitsverteilung gehorchen. Wegen des hohen Wertes von $T_e$ kann die Elektronen-Komponente eines solchen Niederdruckplasmas auch zur Ionisierung von Fremdteilchen dienen, die in das Plasma gebracht werden.

Beispielsweise können in das Plasmagefäß 1 der Ionenquelle Metallteilchen (Atome oder Moleküle) in der Form eingeführt werden, daß auf der Abschlußplatte 8 des Plasmagefäßes 1, die der Ionenaustrittsfläche 21 gegenüberliegt, ein Sputtertarget 10 aus einem beliebigen Metall angeordnet wird (Fig. 6). Erteilt man diesem Sputtertarget 10, das auf Isolierstützen 22 ruht, gegenüber dem Plasma 19 ein negatives Potential, so wird es durch Plasmaionen beschossen, wodurch aus der Targetoberfläche Metallatome ausgelöst werden und in das Plasmavolumen eintreten. Dort werden sie mit einer Wahrscheinlichkeit, die in der Größenordnung von 1 % liegt, durch Stoß mit Plasmaelektronen ionisiert. Sie können dann in analoger Weise wie die Plasmaionen selbst durch die benutzte ionenoptische Anordnung in Form eines Ionenstrahles extrahiert werden. Besonders wichtig ist in diesem Zusammenhang, daß die durch Ionenbeschuß ausgelösten (zerstäubten) Metallatome oder -moleküle eine kinetische Energie besitzen, die erheblich über derjenigen der Plasmaionen selbst liegt. Die mittlere Energie der zerstäubten Metallteilchen liegt in der Regel bei 15 - 20 eV (Elektronenvolt), während die Plasmaionen das Plasma lediglich mit einer Energie von wenigen (4 - 5) eV (Elektronenvolt) verlassen. Auf diese Weise gelingt es durch den Einbau einer geeigneten elektrischen Potentialstufe ($U_2$) bei der Ionenextraktion die nachioinisierten Metallteilchen von den Ionen des Arbeitsgases zu trennen und auf diese Weise einen reinen Metallionenstrahl zu erzeugen.

Eine weitere Möglichkeit, Metallatome in das Plasma 19 einzubringen, besteht darin, hinter der Abschlußplatte 8 des Plasmagefäßes 1, die dem Extraktionssystem 9 gegenüberliegt, ein Vakuum-Gefäß 12 anzuordnen, in dem durch Widerstandsverdampfung oder durch Elektronenstrahlverdampfer 13 ein Metalldampfstrom erzeugt wird, der durch geeignete Öffnungen 11 in der Abschlußplatte 8 in das Plasma 19 eintritt. Eine entsprechende Anordnung ist in Fig. 7 skizziert. Die eintretenden Metallatome und -moleküle werden ebenfalls durch die Plasmaelektroden ionisiert und können dann gemeinsam mit den Ionen des Arbeitsgases in der beschriebenen Weise zu einem Ionenstrahl extrahiert werden. Da sich hier die kinetischen Energien der verschiedenen Teilchenarten nicht unterscheiden, müssen zusätzliche Maßnahmen getroffen werden, mit denen sich die Metallionen von den Plasmaionen trennen lassen. Solche Anordnungen bestehen beispielsweise aus geeignet konfigurierten Gleichmagnetfeldern oder Kombinationen aus Gleichmagnetfeldern und elektrischen Gleichfeldern.

Da solche Trennverfahren in der Regel die Massenunterschiede der verschiedenen Teilchenkomponenten in einem gemischten Teilchenstrahl ausnutzen, bietet sich hier vorzugsweise Helium als Arbeitsgas für die Plasmaerzeugung an. Ein Heliumplasma besitzt auf der einen Seite eine besonders hohe Elektronentemperatur $T_e$, wodurch eine besonders hohe Ionisierungswahrscheinlichkeit für die eintretenden Metallatome gewährleistet wird. Zum anderen besitzen die Heliumionen im Vergleich zu allen Metallatomen eine geringe Masse, was sich auf die Separation von Arbeitsgas- und Metallionen besonders günstig auswirkt.

6

Die Art der in das durch Elektronenzyklotronwellen-Resonanz angeregte Plasma eintretende Teilchen ist nicht auf Metallatome oder -moleküle beschränkt, da sich durch geeignete Anordnungen auch elektrisch nichtleitende Materialien in Dampfform überführen lassen. Besonders geeignet hierfür ist die Methode der sogenannten Hochfrequenz-Zerstäubung, bei der einem Target aus isolierendem Material gegenüber einem Plasma ein Hochfrequenzpotential erteilt wird. Dieses Verfahren der Hochfrequenz-Zerstäubung läßt sich auf einfache Weise mit der entwickelten Hochfrequenz-Ionenquelle kombinieren. Dazu ist das auf der Abschlußplatte 8 (Fig. 6) sitzende Sputtertarget 10 durch ein entsprechendes Isolatortarget zu ersetzen, dem dann in bekannter Weise ein Hochfrequenz-Potential gegen das Potential des Plasmas 19 erteilt wird. In vorteilhafter Weise läßt sich die hierfür benötigte Hochfrequenzspannung zusätzlich dem Hochfrequenzgenerator 4 entnehmen, der zur Plasmaerzeugung mit Hilfe der Elektronenzyklotronwellen-Resonanz verwendet wird.

Wie dargelegt, lassen sich mit Hilfe der beschriebenen Hochfrequenz-Ionenquelle großflächige Ionenstrahlen mit beliebiger Querschnittsgeometrie, z.B. in Bandform, aus Ionen beliebiger Art erzeugen.

## Patentansprüche

1. Hochfrequenz-Ionenquelle zur Erzeugung von großflächigen Ionenstrahlen mit einem Gefäß für die zu ionisierenden Stoffe, insbesondere Gase, wobei induktiv Hochfrequenzenergie in das Plasma einkoppelbar ist und dem Plasma ein Gleichmagnetfeld überlagert ist, **dadurch gekennzeichnet,** daß in einem rohrförmigen, der Form des gewünschten Ionenstrahls angepaßten Plasmagefäß (1), das zwischen eine Trägerplatte (7) und eine Abschlußplatte (8) geklemmt ist, bei Gasdrücken im Hochvakuum-Bereich eine Plasmaanregung durch Elektronenzyklotronwellen resonant in Bezug auf die Plasmagefäß-Dimension durchführbar ist, daß zwischen dem Hochfrequenzgenerator (4) und der Lastkreisspule (2) ein abstimmbarer Zwischenkreis (5) angeordnet ist, daß das schwache Gleichmagnetfeld, das aufgrund der Theorie der Elektronenzyklotronwellen-Resonanz senkrecht zur Achse der Lastkreisspule (2) gerichtet sein muß und dessen Höhe sich aus dieser Theorie ergibt, mit einem Helmholtz-Spulenpaar (6) erzeugt ist, dessen geometrische Gestalt der Form des Plasmagefäßes (1) angepaßt ist und daß in der Trägerplatte (7) ein aus mehreren Elektroden bestehendes ionenoptisches, der Geometrie des gewünschten Ionenstrahls angepaßtes System zur Ionenextraktion (9) angeordnet ist.

2. Hochfrequenz-Ionenquelle nach Anspruch 1, **dadurch gekennzeichnet**, daß als System zur Ionenextraktion (9) eine erste und eine zweite Extraktionselektrode ($E_1$, $E_2$) vorgesehen sind, an die eine Spannung ($U_2$) als Potentialstufe zur Trennung nachionisierter injizierter Fremdteilchen von Plasmaionen angelegt werden kann und daß weitere Elektroden ($E_3$, $E_4$, ...$E_n$) mit angelegten Ionenbeschleunigungsspannungen ($U_3$, $U_4$, ...$U_n$) und eine Suppressionselektrode ($E_s$) mit einer Suppressionsspannung ($U_s$) vorgesehen sind.

3. Hochfrequenz-Ionenquelle nach Anspruch 2, **dadurch gekennzeichnet**, daß die erste Extraktionselektrode ($E_1$) aus nichtleitfähigem Material hergestellt ist und die Spannungen ($U_3$...$U_n$) der weiteren Elektroden gegen die zweite Extraktionselektrode ($E_2$) angelegt sind.

4. Hochfrequenz-Ionenquelle nach Anspruch 1, **dadurch gekennzeichnet**, daß das Plasmagefäß (1) quaderförmig mit abgerundeten Seiten und offenen Stirnflächen ausgebildet ist und das System zur Ionenextraktion (9) schlitzförmige Elektroden ($E_1$...$E_n$, $E_s$) aufweist.

5. Hochfrequenz-Ionenquelle nach Anspruch 1, **dadurch gekennzeichnet,** daß auf der Abschlußplatte (8) ein Zerstäubungstarget (10) angeordnet ist.

6. Hochfrequenz-Ionenquelle nach Anspruch 1, **dadurch gekennzeichnet**, daß die Abschlußplatte (8) über Öffnungen (11) mit einem Vakuum-Gefäß (12) verbunden ist, in dem Widerstands- oder Elektronenstrahl-Verdampfer (13) angeordnet sind.

## Claims

1. A high frequency ion source for generating large-area ion beams, comprising a vessel for the substances, particularly gases, to be ionised, inductive high-frequency energy being adapted for coupling in the plasma and a DC magnetic field being superposed on the plasma, characterised in that plasma excitation by electron cyclotron waves is adapted to be brought about in a tubular plasma

EP 0 349 555 B1

vessel (1) matching the shape of the desired ion beam and clamped between a carrier plate (7) and an end plate (8), at gas pressures in the high-vacuum region and with resonance relative to the size of the plasma vessel, a tunable intermediate circuit (5) is disposed between the high-frequency generator (4) and the load circuit coil (2), the weak DC magnetic field, which according to the theory of electron cyclotron wave resonance must be directed at right angles to the axis of the load circuit coil (2) and the value of which is given by the aforementioned theory, is generated by a pair of Helmholtz coils (6) having a geometric shape adapted to that of the plasma vessel (1), and an ion-optical system for ion extraction (9), adapted to the geometry of the desired ion beam and consisting of a number of electrodes, is disposed in the carrier plate (7).

2. A high-frequency ion source according to claim 1, characterised in that the system for ion extraction (9) comprises a first and a second extraction electrode ($E_1$, $E_2$), to which a voltage ($U_2$) can be applied as a potential stage for separating subsequently-ionised injected foreign particles from plasma ions, and additional electrodes ($E_3$, $E_4$, ... $E_n$) are provided with applied ion acceleration voltages ($U_3$, $U_4$, ... $U_n$) together with a suppression electrode ($E_s$) at a suppression voltage ($U_s$).

3. A high-frequency ion source according to claim 2, characterised in that the first extraction electrode ($E_1$) is made of non-conductive material and the voltages ($U_3$ ... $U_n$) of the other electrodes are applied against the second extraction electrode ($E_2$).

4. A high-frequency ion source according to claim 1, characterised in that the plasma vessel (1) is a cuboid with rounded sides and open end faces and the system (9) for extracting ions has slot-shaped electrodes ($E_1$ ... $E_n$, $E_s$).

5. A high-frequency ion source according to claim 1, characterised in that an atomisation target (10) is disposed on the end plate (8).

6. A high-frequency ion source according to claim 1, characterised in that the end plate (8) is connected by openings (11) to a negative-pressure vessel (12) in which resistance or electron-beam vaporisers (13) are disposed.

**Revendications**

1. Source d'ions de haute fréquence pour produire des faisceaux d'ions de grande surface comprenant un réservoir pour la matière à ioniser, en particulier des gaz, de l'énergie haute fréquence pouvant être fournie par induction au plasma et un champ magnétique uniforme étant superposé au plasma, caractérisée en ce que, dans un réservoir à plasma (1) de forme tubulaire associé à la forme désirée du faisceau d'ions, qui est bloqué entre une plaque support (7) et une plaque de fermeture (8), il est possible d'effectuer, à des pressions correspondant à un niveau de vide poussé, une excitation de plasma par des électrons de rayonnement cyclotron en résonance par rapport à la dimension du réservoir de plasma, en ce que, entre le générateur haute fréquence (4) et le bobinage circulaire de charge (2), il est disposé un circuit intermédiaire ajustable (5), en ce que le champ magnétique uniforme faible qui, selon la théorie de la résonance d'électrons de rayonnement cyclotron, doit être dirigé perpendiculairement à l'axe du bobinage circulaire de charge (2) et dont l'amplitude est donnée par cette théorie, est fourni par une paire de bobines (6) de Helmholtz, dont la configuration géométrique épouse la forme du réservoir de plasma (1), et en ce qu'une optique ionique à plusieurs électrodes pour l'extraction d'ions est adaptée à la forme du faisceau ionique désiré et est montée sur la plaque support.

2. Source d'ions de haute fréquence selon la revendication 1, caractérisée en ce que, en tant que système pour l'extraction d'tons (9), il est prévu une première et une deuxtème électrode d'extraction ($E_1$, $E_2$), sur lesquelles peut être appliquée une tension ($U_2$) en échelon de potentiel pour la séparation de particules injectées post-ionisées des ions de plasma, et en ce qu'il est prévu des électrodes supplémentaires ($E_3$, $E_4$,...$E_n$) sur lesquelles sont appliquées des tensions d'accélération d'ions ($U_3$, $U_4$,...$U_n$) et une électrode de suppression ($E_s$) sur laquelle est appliquée une tension de suppression ($U_s$).

8

3. Source d'ions de haute fréquence selon la revendication 2, caractérisée en ce que la première électrode d'extraction ($E_1$) est réalisée en un matériau non conducteur et les tensions ($U_3...U_n$) des électrodes supplémentaires sont opposées à celle appliquée sur la deuxième électrode d'extraction ($E_2$).

4. Source d'ions de haute fréquence selon la revendication 1, caractérisée en ce que le réservoir de plasma (1) est de forme parallélépipédique à bords arrondis et à face frontale ouverte et le système d'extraction d'ions (9) est muni d'électrodes en forme de fente ($E_1...E_n$, Es).

5. Source d'ions de haute fréquence selon la revendication 1, caractérisée en ce qu'un dispositif de dépoussiérage (10) est monté sur la plaque de fermeture (8).

6. Source d'ions de haute fréquence selon la revendication 1, caractérisée en ce que la plaque de fermeture (8) communique par des ouvertures (11) avec un réservoir de vide (12) dans lequel sont montés des moyens (13) absorbeurs/freineurs de faisceau d'électrons.

FIG. 1

FIG. 2

FIG.3

FIG.4

EP 0 349 555 B1

## FIG.5

## FIG.6

## FIG.7